# EUROPEAN PATENT APPLICATION

(11) **EP 1 956 645 A1**
(43) Date of publication of application: **13.08.2008**
(21) Application number: 06823049.9
(22) Date of filing: 07.11.2006
(51) Int. Cl.: H01L 21/31, C23C 16/455, H01L 21/3065

(54) **SHOWER PLATE AND PLASMA TREATMENT APPARATUS USING SHOWER PLATE**

(30) Priority: 08.11.2005 JP 2005323534
(71) Applicant: TOHOKU UNIVERSITY, Aoba-ku Sendai-shi, Miyagi 980-8577 (JP); Tokyo Electron Ltd., Tokyo 107-8481 (JP)
(72) Inventor: OHMI, Tadahiroc/o Tohoku University, Sendai-shi, Miyagi;9808577 (JP); MATSUOKA, Takaaki, c/o TOKYO ELECTRON LIMITED,, Tokyo;1078481 (JP)
(74) Representative: Glawe, Delfs, Moll
(86) International application number: PCT/JP2006/322136
(87) International publication number: WO 2007/055185

(57) **Abstract**

A shower plate 31 for plasma processing, which is formed by a plurality of pipes, is provided. A pipe 31 A3 comprises a porous material member 44 which is disposed along the pipe, which has a predetermined porosity with respect to a material gas, and which has an outwardly convex shape, and a metal member 41 which is faced to the porous material member 44 and which forms a material gas flow path 43 in combination with the porous material member 44. A nozzle structure capable of releasing the material gas with a spread can be realized.

## Description

### Technical Field:

This invention relates to a shower plate for use in a facility or apparatus for manufacturing a semiconductor device and a semiconductor-related device, in particular, for use in a processing chamber of a plasma processing apparatus, and to a plasma processing apparatus using a shower plate of the type.

### Background Art:

In manufacturing processes of a semiconductor and a semiconductor-related device, a process for forming an oxide film, a nitride film, and an oxynitride film on a substrate surface by oxidation, nitridation, and oxynitridation, respectively, or by CVD, and a process for removing these films by etching are executed at various stages. In case where a large amount of products of the same type, such as a general-purpose DRAM, are manufactured, these processes are carried out by processing apparatuses for executing respective unique processes. On the other hand, in case of custom LSI products or the like for which high-mix low-volume production is carried out, it is preferable that a plurality of processes are executed by one or a reduced number of apparatuses, because installation of an expensive processing apparatus for each process is undesirable in view of cost.

In order to execute multifunctional processes in a processing apparatus, there is known a technique of forming an oxide film, a nitride film, and an oxynitride film by causing oxygen radicals and nitrogen radicals excited by plasma to react with a substrate surface or another technique of depositing an oxide film and a nitride film by causing these radicals to react with a silane (SiH₄) gas.

Japanese Unexamined Patent Application Publication (JP-A) No. 2002-299331 (patent document) discloses an apparatus of the type. According to the document, a chamber (processing chamber) of the processing apparatus is provided with an upper shower plate made of a dielectric material and adapted to substantially uniformly emit a gas for generating plasma and radicals toward a lower side of the processing chamber, a lower shower plate comprising pipes which have a large number of small apertures adapted to substantially uniformly emit a reactive gas toward a substrate and which are arranged in a lattice pattern so as to form a large number of openings or spaces allowing the plasma or excited radicals from the upper shower plate to pass therethrough, and an antenna for radiating, from a position above the upper shower plate toward the upper shower plate, microwave for generating the plasma. In case where the substrate is oxidized to form an oxide film, an Ar gas, a Kr gas, and an oxygen gas are supplied from the upper shower plate and plasma is generated by microwave. A substrate surface is exposed to oxygen radicals excited there to form the oxide film. Further, in case where a nitride film is deposited by plasma CVD, an Ar gas, a Kr gas, and an ammonia (NH₃) gas are supplied to the upper shower plate and plasma is generated by microwave. Nitrogen radicals excited there and a silane (SiH₄) gas emitted from the lower shower plate are reacted with each other to deposit a silicon nitride film (Si₃N₄) on the substrate.

In reactive ion etching, an Ar gas and a Kr gas are introduced from the upper shower plate and plasma is generated by microwave. A CₓH_{y} gas as a reactive gas is introduced from the lower shower plate, and a bias voltage is applied to the substrate. Thus, a silicon oxide film on the substrate can be etched.

Patent Document 1: Japanese Unexamined Patent Application Publication (JP-A) No. 2002-299331

### Disclosure of the Invention:

### Problem to be Solved by the Invention:

The lower shower plate used in the conventional plasma processing apparatus has a structure in which pipes are arranged like a lattice and each pipe has a plurality of nozzles which have the same shape and which are disposed at predetermined intervals. Interior spaces of the pipes are connected to one another to form a passage for a raw material gas to be supplied. A flow rate of the raw material gas from each nozzle is determined by a pressure of the raw material gas at a nozzle inlet corresponding to a nozzle outlet. As long as the pressure of the raw material gas at each nozzle inlet is kept constant, the raw material gas is ejected at a substantially uniform flow rate from the nozzles at both of a center portion and a peripheral portion of the shower plate since the nozzles have the same characteristics.

However, in the conventional shower plate, a flow velocity of the raw material gas is as high as several hundreds m/second to several km/second due to a nozzle structure. Therefore, it is difficult to control a gas flow pattern inside the chamber.

In the conventional shower plate, ejection of the raw material gas is concentrated to an area right under the nozzle and does not spread to a peripheral area around the area right under the nozzle. Therefore, it is difficult to eject the raw material gas with a spread in a transverse direction.

Further, the lower shower plate is disadvantageous as follows. Due to recombination of ions and electrons in plasma, the lower shower plate is elevated in temperature to be mechanically deteriorated or deformed if it is formed of a material easily affected by heat. Even if the material is resistant to heat, deflection or deformation is caused due to nonuniform temperature elevation.

It is therefore an object of the present invention to provide a shower plate for a plasma processing apparatus, which is capable of controlling a gas flow pattern by decreasing a flow velocity of a raw material gas.

It is another object of the present invention to provide a shower plate for a plasma processing apparatus, which is provided with nozzles capable of ejecting a raw material gas with a spatial spread.

It is still another object of the present invention to provide a shower plate for a plasma processing apparatus, which is capable of effectively controlling temperature elevation of the shower plate due to recombination of ions and electrons in plasma.

### Means to Solve the Problem:

According to this invention, there is provided a shower plate for a plasma processing apparatus, wherein a plurality of pipe members are disposed with a space portion left between adjacent ones of the pipe members, each of the pipe members defining, within each pipe member, a first gas flow path and a second gas flow path which is coupled to the first gas flow path and which includes a porous material member having a permeability for a process gas.

The second gas flow path has an outwardly convex shape in a sectional plane having a minimum sectional area.

Desirably, the second gas flow path has a thickness in the sectional plane, which is thickened at the center and is decreased toward the periphery.

The porous material member at the center of the second gas flow path may have a porosity different from that of the porous material member at the periphery of the second gas flow path.

Desirably, the pipe member has a refrigerant gas flow path formed therein.

According to this invention, there is provided a shower plate for a plasma processing apparatus wherein a plurality of pipe members are disposed with a space portion left between adjacent ones of the pipe members, each of the pipe members comprising, within each pipe member, a first gas flow path for allowing a predetermined gas to flow therethrough, a second gas flow path connected to the first gas flow path to release the predetermined gas to the outside, and a third gas flow path for allowing a refrigerant gas to flow therethrough.

In this case, it is desired that the first gas flow paths are coupled to one another within the plurality of the pipe members, the third gas flow path being disposed in parallel with the first gas flow path.

Preferably, each pipe member is formed of an alloy containing copper and tungsten.

In this case, it is desired that the alloy of copper and tungsten is an alloy containing 10-20% copper and 90-80% tungsten.

10. The shower plate for a plasma processing apparatus as claimed in any one of claims 1 through 5 and 8 through 9, wherein the porous material member is formed of a number of thin metallic wires.

The thin metallic wire comprises a copper-tungsten alloy.

Desirably, the thin metallic wire is provided with an yttrium oxide coating film.

Desirably, each pipe member has an outer surface coated with an yttrium oxide film.

The pipe members may be disposed circularly or in a lattice pattern.

According to this invention, there is provided a plasma processing apparatus which uses the above-mentioned shower plate for plasma processing.

The shower plate for plasma processing is provided as a lower shower plate.

According to this invention, there is provided a plasma processing method in which a process gas is introduced into a plasma apparatus by using the above-mentioned shower plate and plasma processing is carried out on a substrate.

According to this invention, there is also provided a method of manufacturing an electronic device, the method including the plasma processing mentioned above.

### Effect of the Invention:

In the shower plate of the present invention, an ejection port for a raw material gas is formed of a porous material. Therefore, it is possible to decrease a flow velocity from the ejection port to thereby create a controlled gas flow pattern.

The shower plate of the present invention has a structure in which the raw material gas is ejected through a porous material member which is formed along a pipe and which has an outwardly convex shape. Therefore, it is possible to eject the raw material gas in a direction of the pipe with a spread in a transverse direction. Thus, the raw material gas can uniformly reach a substrate surface.

Further, in the present invention, a fluid passage for a refrigerant is formed within the pipe along a material gas flow path. Therefore, it is possible to control temperature elevation of the shower plate due to recombination of electrons and ions in plasma. Consequently, the lower shower plate can be prevented from deflection and mechanical deformation. In case where the lower shower plate is made of a material easily affected by heat (for example, an aluminum alloy and so on), deterioration due to heat can be prevented.

### Brief Description of the Drawing:

Fig. 1 is a schematic view of a plasma processing apparatus according to the present invention.
Fig. 2 is a plan view of a slot plate of the plasma processing apparatus illustrated in Fig. 1.
Fig. 3 is a plan view of a lower shower plate according to a first embodiment of the present invention.
Fig. 4 is a schematic perspective view of a circular pipe of the lower shower plate in Fig. 3.
Fig. 5 (a) is a sectional view perpendicular to a drawing sheet and taken along a line AA in Fig. 3, (b) is a detailed sectional view of an individual pipe, and (c) is a sectional view showing a state where a material gas is ejected.
Fig. 6 is a plan view of a lower shower plate according to a second embodiment of the present invention as seen from an upper side.
Fig. 7 is a plan view of the lower shower plate according to the second embodiment of the present invention as seen from a lower side.
Fig. 8 is a sectional view perpendicular to a drawing sheet and taken along a line BB in Fig. 6 and Fig. 7.

### Description of Reference Numerals:

10 microwave plasma processing apparatus
11 processing chamber
12 substrate
13 holding stage
14 upper shower plate
14A nozzle aperture
15 cover plate
17 antenna body
20 radial line slot antenna
31 lower shower plate
31A1, 31A2, 31A3, 31A4 circular pipe
31 C1, 31 C2, 31 C3, 31 C4 opening portion
31 F1, 31 F2, 31 F3, 31 F4 coupling pipe
31 H horizontal pipe
31 V vertical pipe
41 metal member
42 refrigerant flow path
43 material gas flow path
44 porous material member
45 yttrium oxide film
46 first pipe member
47 second pipe member

### Best Mode for Embodying the Invention:

Hereinbelow, embodiments of the present invention will be described.

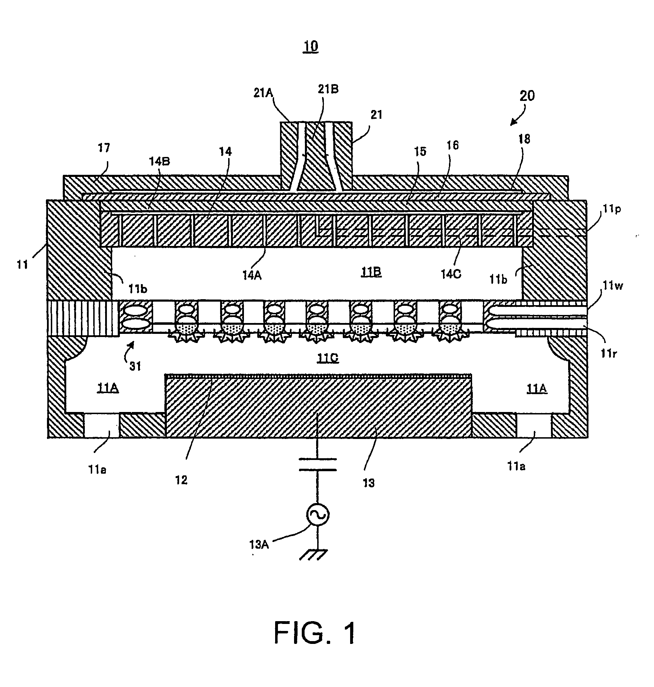

Fig. 1 shows a structure of a microwave plasma processing apparatus 10 as a semiconductor and flat plate display manufacturing apparatus in which a shower plate according to the present invention is used.

In Fig. 1, a process chamber of the manufacturing apparatus is a chamber for a microwave-excited plasma process, which is capable of carrying out a plurality of processes, such as CVD, RIE, oxidation, and nitridation. Inside a processing chamber (vacuum chamber) 11, an upper shower plate 14 made of ceramics and having upper gas supply ports with ejection ports uniformly opened, and a lower shower plate (process gas supply structure) 31 having continuous nozzles for ejecting a material gas from a lower stage are disposed.

Inside the processing chamber (process chamber) 11, a holding stage 13 is disposed which is for holding, by an electrostatic chuck, a substrate 12 to be processed and which is preferably formed of AIN or Al₂O₃ by hot isostatic pressing (HIP). Inside the processing chamber 11, at least two, preferably three or more exhaust ports 11a are formed in a space 11A surrounding the holding stage 13 at an equal distance, specifically, with a generally axisymmetric relation with respect to the substrate 12 on the holding stage 13. The processing chamber 11 is evacuated and reduced in pressure via the exhaust ports 11 a by an irregular pitch irregular inclination screw pump.

On the upper shower plate 14, a cover plate 15 is arranged via a seal ring, which is made of dense Al₂O₃ and formed by similar HIP processing. The shower plate 14 is provided with a plasma generation gas flow path 14B formed on a side in contact with the cover plate 15 and communicating with each of nozzle apertures 14A. The plasma generation gas flow path 14B is formed inside the shower plate 14 and communicates with another plasma generation gas flow path 14C which communicates with a plasma inlet 11p formed on an outer wall of the processing chamber 11.

The shower plate 14 is held by a protruding portion 11 b formed on an inner wall of the processing chamber 11. The protruding portion 11 b is provided with roundness (not shown) formed at a part holding the shower plate 14 to suppress abnormal electrical discharge.

A plasma generation gas, such as Ar or Kr, supplied to the plasma inlet 11p successively passes through the flow paths 14C and 14B inside the shower plate 14 and, thereafter, is uniformly supplied to a space 11 B right under the shower plate 14 via the apertures 14A.

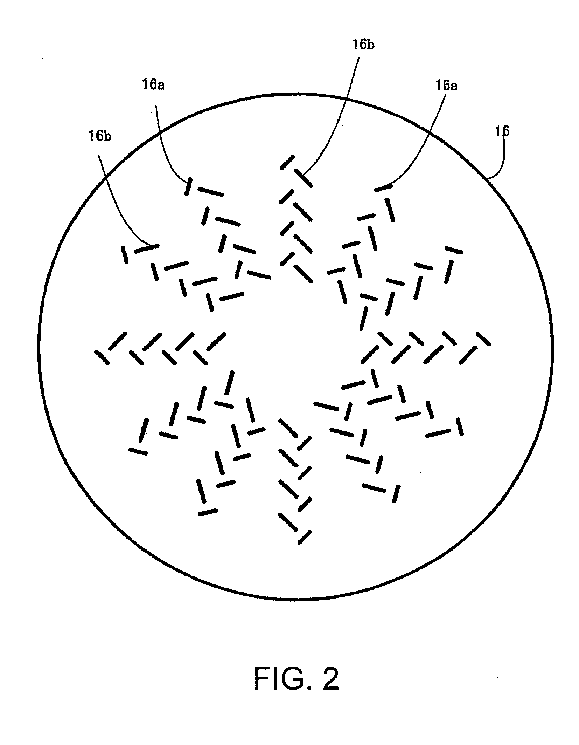

On the cover plate 15, there is provided a radial line slot antenna 20 comprising a disk-shaped slot plate 16 (see Fig. 2) arranged in close contact with the cover plate 15 and having a number of slots 16a and 16b formed thereon, a disk-shaped antenna body 17 for holding the slot plate 16, and a retardation plate 18 made of a low-loss dielectric material, such as Al₂O₃, SiO₂, or Si₃N₄, and sandwiched between the slot plate 16 and the antenna body 17.

The radial slot line antenna 20 is mounted on the processing chamber 11 via a seal ring (not shown). The radial line slot antenna 20 is supplied with microwave having a frequency of 2.45GHz or 8.3GHz from an external microwave source (not shown) via a coaxial waveguide 21.

The microwave thus supplied is emitted into the interior of the processing chamber 11 from the slots 16a and 16b (see Fig. 2) on the slot plate 16 via the cover plate 15 and the shower plate 14 and, in the space 11 B right under the shower plate 14, causes excitation of plasma in the plasma generation gas supplied from the apertures 14A. At this time, the cover plate 15 and the shower plate 14, which are formed of Al₂O₃, function as an efficient microwave-transmitting window.

The coaxial waveguide 21 has an outer waveguide 21A connected to the disk-shaped antenna body 17, and a central conductor 21 B connected to the slot plate 16 via an opening or a space portion formed on the retardation plate 18. The microwave supplied to the coaxial waveguide 21A travels in a radial direction between the antenna body 17 and the slot plate 16 and is emitted from the slots 16a and 16b.

Referring to Fig. 2, the slots 16a are arranged in a concentric pattern. The slots 16b corresponding to the slots 16a and perpendicular thereto are formed likewise in a concentric pattern. The slots 16a and 16b are formed in the radial direction of the slot plate 16 with an interval corresponding to a wavelength of the microwave compressed by the retardation plate 18. As a result, the microwave is emitted from the slot plate 16 as a substantial plane wave. In this event, the slots 16a and 16b are formed in a mutually perpendicular relationship, which brings about occurrence of a circularly polarized wave which includes two perpendicular polarization components in the emitted microwave.

Referring to Fig. 1 again, the lower shower plate (process gas supply structure) 31 is disposed between the upper shower plate 14 and the substrate 12 on the holding stage 13 in the processing chamber 11 of the microwave plasma processing apparatus 10. The lower shower plate is provided with pipes constructing a process gas passage which is supplied with a process gas (raw material gas) from a process gas inlet 11 r formed on the outer wall of the processing chamber 11 and delivers the gas to a number of process gas nozzle portions. The pipes have a structure which will later be described and a plurality of apertures are formed between the pipes. In a space 11C between the lower shower plate 31 and the substrate 12, desired uniform substrate processing is carried out. Such substrate processing includes plasma oxidation processing, plasma nitridation processing, plasma oxynitridation processing, plasma CVD processing, and so on. Further, it is possible to conduct reactive ion etching on the substrate 12 by supplying a readily dissociable fluorocarbon gas, such as C₄F₈, C₅F₈, or C₄F₆, or an F-based or a Cl-based etching gas from the process gas supply structure 31 to the space 11C and by applying a high-frequency voltage from a high-frequency power source 13A to the holding stage 13.

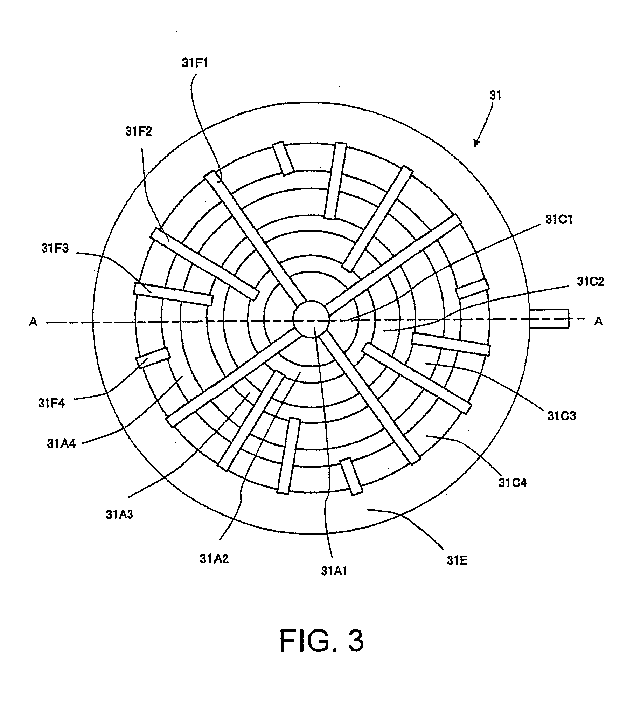

Referring to Fig. 3, the lower shower plate of the present invention will be described. Fig. 3 is a plan view of the lower shower plate as seen from the side of the upper shower plate. The lower shower plate has a plurality of circular pipes 31A1, 31A2, 31 A3, and 31 A4 which are concentrically arranged. These pipes are connected to a circular frame pipe (base pipe) 31 E by coupling pipes 31F1, 31 F2, 31 F3, and 31 F4, respectively. Between the circular pipes adjacent to one another, opening portions 31C1, 31 C2, 31 C3, and 31 C4 are formed, respectively. Through these opening portions, the plasma generated in the space 11 B under the upper shower plate is diffused from the upper side of the lower shower plate toward the lower side thereof.

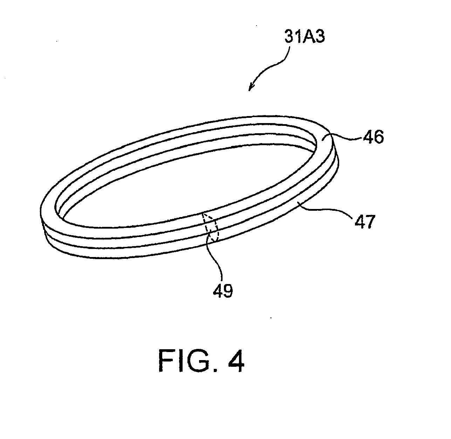

Fig. 4 is a schematic perspective view of the circular pipe 31 A3 shown in Fig. 3. The circular pipe 31A3 comprises a first pipe member 46 and a second pipe member 47. The circular pipe 31A3 has a sectional portion 49 which is perpendicular to the pipe.

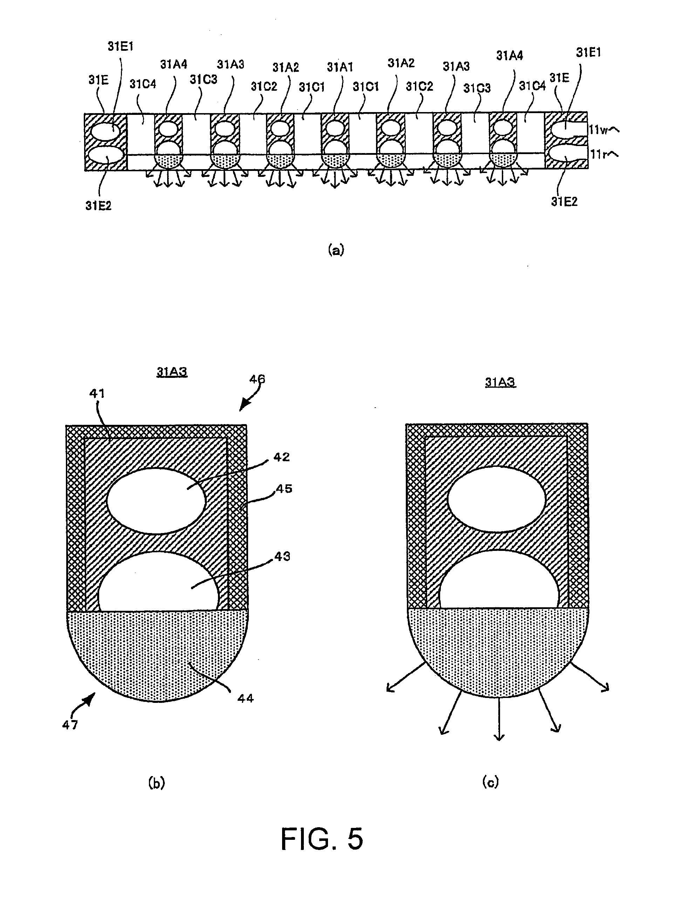

Referring to Fig. 5(b), details of the sectional portion 49 shown in Fig. 4 are illustrated. The first pipe member 46 of the circular pipe 31 A3 comprises a metal member 41 of a circular alloy comprising a Cu-W (copper-tungsten) alloy and an yttrium oxide (Y₂O₃) thin film 45 formed on an outer surface thereof. The circular alloy has, in the interior thereof, a material gas flow path 43 constituting a flow path for a material gas in combination with the second pipe member 47, and a refrigerant flow path 42 for cooling the shower plate. The second pipe member 47 is formed by a porous material member 44. The porous material member 44 has an outwardly convex shape and has a thickness thickened at the center and reduced toward the periphery. The porous material member 44 has an outer surface provided with an yttrium oxide (Y₂O₃) thin film.

The circular pipes 31A2 and 31A4 shown in Fig. 3 also have a shape similar to that of the circular pipe 31A3. Therefore, description thereof will be omitted. The circular pipe 31A1 at the center comprises a cylindrical first pipe member and a second pipe member having an outer surface forming a part of a sphere. The circular pipe has a rotationally-symmetric shape with respect to its central axis. A section passing through the central axis has a shape substantially similar to that shown in Fig. 5(b) and, hence, description thereof will be omitted. In the interior, a material gas flow path and a refrigerant flow path are formed.

Fig. 5(a) shows a section perpendicular to a drawing sheet and taken along a line AA in Fig. 3. On both sides of the central pipe 31A1, the circular pipes 31 A2, 31 A3, and 31 A4 are disposed. As spaces between adjacent ones of the pipes, opening portions 31C1, 31 C2, 31 C3, and 31 C4 are formed. In Fig. 5(a), each of the circular pipes 31A2, 31A3, and 31A4 has a detailed section of a structure shown in Fig. 5(b). In Fig. 5(a), simplified illustration is given.

The circular frame pipe 31 E has a material gas flow path 31 E1 and a refrigerant gas flow path 31 E2 formed inside and connected to the material gas flow path 43 and the refrigerant gas flow path 42 of the circular pipes 31A1, 31A2, 31 A3, and 31A4 by the coupling pipes 31 F1, 31 F2, 31 F3, and 31 F4, respectively.

Further, the circular frame pipe is connected to a material gas supply port 11 r and a refrigerant gas supply port 11 w through pipes.

A material for the first pipe member of the circular pipe is required to have a sufficiently high thermal conductivity. As a Cu-W alloy used in the present embodiment, an alloy containing 10-20% Cu and 90-80% W is used so as to satisfy the above-mentioned requirement. In this alloy, a thermal conductivity of 80-200W/m.K is obtained. Further, this alloy has a thermal expansion coefficient of 7 to 8 x 10⁻⁶/K which is approximately equal to a thermal expansion coefficient of 7 to 8 x 10⁻⁶/K of Y₂O₃. Therefore, as a protection film, the Cu-W alloy can be coated with a thick Y₂O₃ film. The yttrium oxide film is formed to a thickness of approximately 200 µm by plasma spraying. This Y₂O₃ film has pores allowing a material gas to pass through.

For the yttrium oxide film, a plasma spraying apparatus has a structure in which an yttria powder raw material is supplied to a plasma generating portion so that the material can be sufficiently melted upon plasma spraying. Thus, the material is sufficiently melted.

As the porous material member 44, it is possible to use a metal filter coated with ceramics. Specifically, the porous material member has a metal filter structure formed by a material comprising thin metallic wires of a copper-tungsten alloy each of which is coated with yttrium oxide (Y₂O₃). That is, surfaces of pores of the metal filter are coated with yttrium oxide. By selecting a porosity of the metal filter, an ejection flow velocity of the material gas can be controlled. By using such a porous material, the flow velocity of the material gas can be decreased from several tens cm/second to several cm/second to thereby control a gas flow pattern.

Further, as shown in Fig. 5(c), the porous material member is increased in thickness from the center toward the periphery so that the material gas can be ejected with a spread. Therefore, by partial overlap with the spread of a gas ejected from a material gas outlet of an adjacent pipe, uniform distribution of the material gas can be ejected.

Furthermore, by varying a material quality of the porous material, it is possible to vary the flow rate of the material gas ejected from each of the circular pipe and to thereby provide a distribution in the flow rate of the material gas. For example, in Fig. 5(a) and Fig. 3, a gas flow rate V1 from the porous gas outlets of the center circular pipe 31 A1 and the next circular pipe 31 A2 is made greater than a gas flow rate V2 from the porous gas outlets of the circular pipe 31A3 and the next circular pipe 31A4. For this purpose, for the circular pipes 31A1 and 31 A2, a material having a porosity greater than that of the circular pipes 31A3 and 31A4 is adopted. Alternatively, instead of varying the porosity, the porous material for the circular pipes 31A1 and 31A2 may be decreased in thickness in comparison with the circular pipes 31A3 and 31A4. Thus, by varying the porosity or by varying the thickness of the porous material, the ejection flow rate of the material gas is changed between the central portion and the peripheral portion of the shower plate to thereby vary the amount of supply of the material gas.

In place of the Cu-W alloy, an Al alloy may be used. However, the Al alloy has a thermal expansion coefficient as extremely great as 23 x 10⁻⁶/K. Consequently, there is a possibility of occurrence of cracks in the Y₂O₃ film as a surface protection film thereof. Therefore, it is required to decrease the thermal expansion coefficient to a. level as small as that of the Cu-W alloy, for example, by impregnating silicon carbide (SiC) or carbon (C) fibers with Al. Then, the material must be capable of being subjected to precision machining, such as formation of fine holes in the circular pipe.

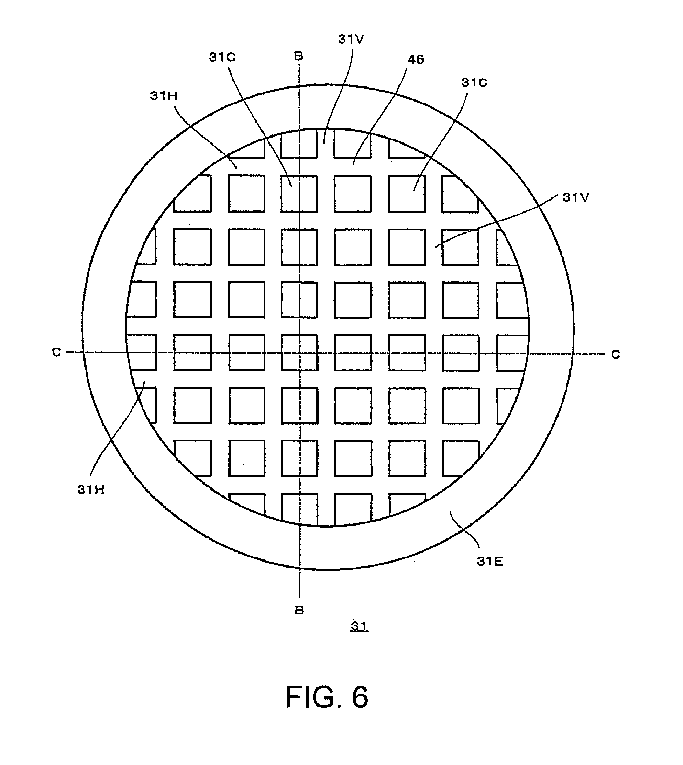

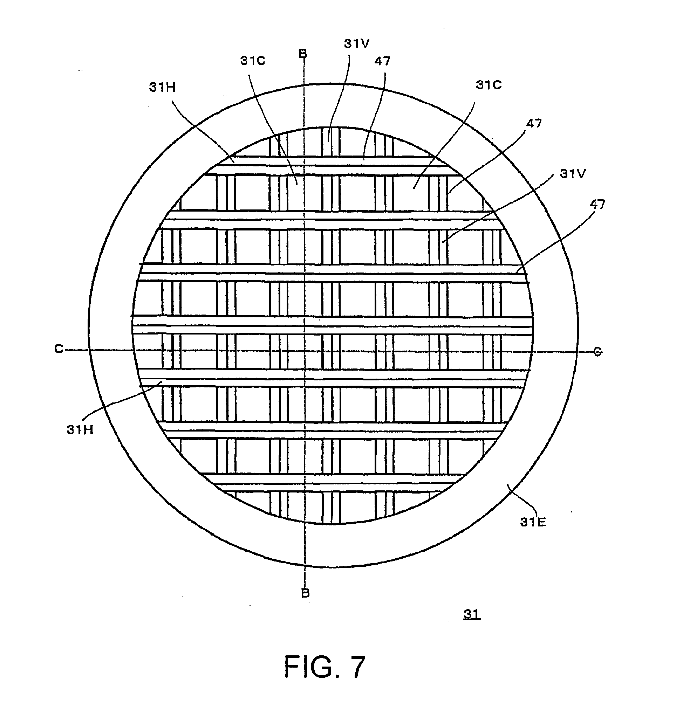

Fig. 6 and Fig. 7 relate to a second embodiment of the lower shower plate of the present invention. Fig. 7 is a plan view as seen from the side of the upper shower plate, while Fig. 7 is a plan view of a rear surface as seen from the side of the substrate to be processed.

A major difference between the second embodiment and the first embodiment is that the circular pipes are concentrically disposed in the first embodiment While, in the present embodiment, the pipes except the circular frame pipe are arranged in a lattice pattern.

Referring to Fig. 6 and Fig. 7, pipes arranged in a lattice pattern are connected to the circular frame pipe 31 E having a material gas passage and a refrigerant gas flow path formed inside. In a horizontal direction of the lattice-patterned pipes, a plurality of horizontal pipes 31 H parallel to one another are disposed. In a vertical direction perpendicular to the horizontal pipes, a plurality of vertical pipes 31V parallel to one another are disposed. Each of the horizontal pipes and the vertical pipes has a material gas flow path and a refrigerant gas flow path formed therein. These flow paths are connected to the material gas flow path and the refrigerant gas flow path of the circular frame pipe 31 E, respectively.

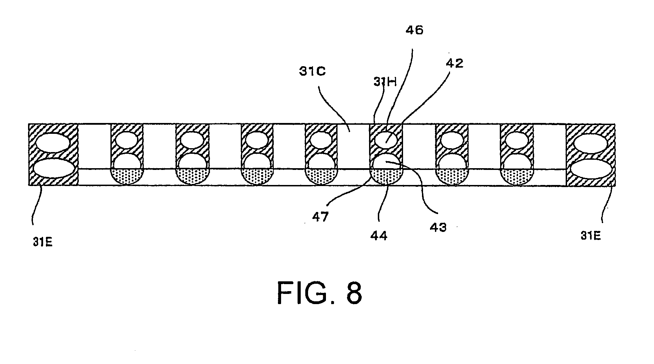

Referring to Fig. 8, a section perpendicular to the drawing sheet and taken along a line BB in Fig. 6 and Fig. 7, is shown. This section is similar to Fig. 5(a) in the first embodiment. In Fig. 8, the horizontal pipes 31 H are arranged at equal intervals and an opening portion 31 C as a plasma flow path is formed between adjacent ones of the horizontal pipes. Each of the horizontal pipes 31 H comprises a first pipe member 46 having a refrigerant flow path 42 and a raw material gas flow path 43 formed therein, and a second pipe member 47 facing the pipe member 46 and forming the raw material gas flow path in combination with the pipe member. The second pipe member comprises a porous material member 44 having an outwardly convex hog-backed shape. The details of the first pipe member and the second pipe member are same as those in Fig. 5(b) and Fig. 5(c) related to the first embodiment. Therefore, detailed description thereof is omitted. Briefly, a raw material gas is released through pores of the porous material member 44. Since this porous material member 44 has a shape thickened at the center and thinned toward the periphery, the raw material gas is released with a spread in a transverse direction. In case of the present embodiment also, when materials different in porosity are selected as the porous material member and spatially arranged, it is possible to make the flow rate of the material gas be different between the central portion and the peripheral portion of the lower shower plate. Further, instead of using the materials different in porosity, the porous material member may be different in thickness between the central portion and the peripheral portion of the lower shower plate.

A section taken along a line CC in Fig. 6 and Fig. 7 is substantially same as that taken along the line BB. Therefore, description thereof is omitted. Incidentally, a reference numeral 48 in Fig. 7 corresponds to a ridge line connecting, in a pipe length direction, peaks of the convex portions of the second pipe member having an outwardly convex shape.

As described in the foregoing embodiments, in the lower shower plate of the present invention, the ejection port of the material gas is formed of the porous material member. Therefore, a flow velocity from the ejection port can be decreased to thereby create a controlled gas flow pattern.

As described in the foregoing embodiments, the lower shower plate of the present invention has a structure in which the nozzles are arranged continuously along a direction of the pipe. The material gas can be released with a spread in a transverse direction with respect to a continuing direction of the nozzles. Therefore, a manufacturing apparatus of a semiconductor device and a liquid crystal device, which uses the lower shower plate, can carry out more controlled processing on a substrate.

In the present invention, the refrigerant fluid passage is formed along the material gas flow path within the pipe. Therefore, it is possible to effectively suppress temperature elevation of the shower plate due to recombination of electrons and ions in plasma. Industrial Applicability:

The shower plate according to the present invention is applicable to various types of plasma processing apparatuses and semiconductor manufacturing apparatuses for executing processing, such as CVD and RIE.

## Claims

1. A shower plate for a plasma processing apparatus, wherein a plurality of pipe members are disposed with a space portion left between adjacent ones of the pipe members, each of the pipe members defining, within each pipe member, a first gas flow path and a second gas flow path which is coupled to the first gas flow path and which includes a porous material member having a permeability for a process gas.

2. The shower plate for a plasma processing apparatus as claimed in claim 1, wherein the second gas flow path has an outwardly convex shape in a sectional plane having a minimum sectional area.

3. The shower plate for a plasma processing apparatus as claimed in claim 1, wherein the second gas flow path has a thickness in the sectional plane, which is thickened at the center and is decreased toward the periphery.

4. The shower plate for a plasma processing apparatus as claimed in any one of claims 1 through 3, wherein the porous material member at the center of the second gas flow path has a porosity different from that of the porous material member at the periphery of the second gas flow path.

5. The shower plate for a plasma processing apparatus as claimed in any one of claims 1 through 4, wherein the pipe member has a refrigerant gas flow path formed therein.

6. A shower plate for a plasma processing apparatus wherein a plurality of pipe members are disposed with a space portion left between adjacent ones of the pipe members, each of the pipe members comprising, within each pipe member, a first gas flow path for allowing a predetermined gas to flow therethrough, a second gas flow path connected to the first gas flow path to release the predetermined gas to the outside, and a third gas flow path for allowing a refrigerant gas to flow therethrough.

7. The shower plate for a plasma processing apparatus as claimed in claim 6, wherein the first gas flow paths are coupled to one another within the plurality of the pipe members, the third gas flow path being disposed in parallel with the first gas flow path.

8. The shower plate for a plasma processing apparatus as claimed in any one of claims 1 through 7, wherein each pipe member is formed of an alloy containing copper and tungsten.

9. The shower plate for a plasma processing apparatus as claimed in claim 8, wherein the alloy of copper and tungsten is an alloy containing 10-20% copper and 90-80% tungsten.

10. The shower plate for a plasma processing apparatus as claimed in any one of claims 1 through 5 and 8 through 9, wherein the porous material member is formed of a number of thin metallic wires.

11. The shower plate for a plasma processing apparatus as claimed in claim 10, wherein the thin metallic wire comprises a copper-tungsten alloy.

12. The shower plate for a plasma processing apparatus as claimed in claim 11, wherein the thin metallic wire is provided with an yttrium oxide coating film.

13. The shower plate for a plasma processing apparatus as claimed in any one of claims 1 through 12, wherein each pipe member has an outer surface coated with an yttrium oxide film.

14. The shower plate for a plasma processing apparatus as claimed in any one of claims 1 through 12, wherein the pipe members are circularly disposed.

15. The shower plate for a plasma processing apparatus as claimed in any one of claims 1 through 12, wherein the pipe members are disposed in a lattice pattern.

16. A plasma processing apparatus which uses the shower plate for plasma processing, claimed in any one of claims 1 through 15.

17. The plasma processing apparatus as claimed in claim 16, wherein the shower plate for plasma processing is provided as a lower shower plate.

18. A plasma processing method in which a process gas is introduced into a plasma apparatus by using the shower plate claimed in any one of claims 1 through 15 and plasma processing is carried out on a substrate.

19. A method of manufacturing an electronic device, the method including the plasma processing in claim 18 as one of steps.
